# EUROPEAN PATENT APPLICATION

(11) **EP 4 660 352 A1**
(43) Date of publication of application: **10.12.2025**
(21) Application number: 25180990.1
(22) Date of filing: 05.06.2025
(51) Int. Cl.: C30B 29/12, C30B 7/08

(54) **SPACE-CONFINED TEMPERATURE GRADIENT INDUCED MONOLITHIC (STIM) INTEGRATED GROWTH APPARATUS CAPABLE OF ADJUSTING THICKNESS PEROVSKITE SINGLE CRYSTAL AND GROWING LARGE-AREA PEROVSKITE SINGLE CRYSTAL AND STIM INTEGRATED GROWTH METHOD USING THE SAME**

(30) Priority: 05.06.2024 KR 20240073991; 31.03.2025 KR 20250040941
(71) Applicant: Korea Advanced Institute of Science and Technology, Daejeon 34141 (KR)
(72) Inventor: SHIN, Byungha, Daejeon (KR); CHOI, Youngseung, Daejeon (KR); KIM, Min Kyu, Daejeon (KR)
(74) Representative: M. Zardi & Co S.A.

(57) **Abstract**

A space-confined temperature gradient induced monolithic (STIM) integration growth apparatus capable of adjusting a thickness of a perovskite single crystal and growing a large-area perovskite single crystal may include an upper housing including a storage space in which a perovskite precursor solution is stored, a lower housing coupled to a lower part of the upper housing, and a temperature control device disposed under the lower housing. The lower housing may include a first frame, a second frame disposed to be spaced apart from the first frame, and a spacer that is disposed between the first frame and the second frame and that partitions a growth space for a perovskite single crystal seed.

## Description

### BACKGROUND

### 1. Technical Field

The present disclosure relates to a space-confined temperature gradient induced monolithic (STIM) integration growth apparatus capable of adjusting the thickness of a perovskite single crystal and growing a large-area perovskite single crystal and a method of growing a large-area perovskite single crystal using the same, more particularly, to a growth apparatus and growth method capable of growing a single crystal having a plate form by adjusting the thickness and an area of the single crystal and integrating the single crystal at a desired shape and location of a substrate by using the STIM integration growth method according to an embodiment of the present disclosure, unlike a conventional method of growing a perovskite single crystal, which cannot implement a thickness and area that suit various purposes.

### 2. Related Art

Perovskite is being actively researched as a material for a direct x-ray detector due to its excellent optical characteristics. Perovskite that is used in a sensitive part of the direct x-ray detector is used to absorb an X-ray and detect charges generated from the X-ray.

In order for perovskite to absorb an X-ray having high energy, perovskite needs to have a thickness of 0.5 to 2 mm. In order to well collect electrons and holes generated from the X-ray within the range of such a thickness, the charge diffusion distance of the substance of perovskite itself needs to be long. A perovskite single crystal can satisfy the two conditions of the thickness and the charge diffusion distance.

However, there are some problems to be solved in order for the perovskite single crystal to be used in the direct x-ray detector. In order to effectively absorb and sensitively detect an X-ray, the perovskite single crystal needs to have a thickness of about 0.5 mm to 2 mm and also to have a wide area in a lateral direction thereof. The ratio of the length and thickness of a natural perovskite single crystal in the lateral direction is about 3: 1. That is, although a perovskite single crystal having a length 50 mm is produced, the thickness of the perovskite single crystal is 15 mm or more.

A space-confined method of adjusting the thickness of a perovskite single crystal includes growing a single crystal in a way to insert a spacer that adjusts the thickness of a perovskite single crystal between two substrates that face each other, place a perovskite single crystal seed within the space, and dip the perovskite single crystal seed in a perovskite precursor solution. However, such a method can adjust the thickness of the perovskite single crystal, but has a disadvantage in that it is difficult to grow a large-area single crystal because the substrate that enters the perovskite precursor solution acts as the nucleation center of the perovskite single crystal and thus additional crystals are generated. Furthermore, in order to use the direct x-ray detector in various ranges, such as the medical field, the perovskite single crystal needs to be able to be applied to a TFT panel. That is, in order to apply the perovskite single crystal to a TFT substrate, the perovskite single crystal is not simply combined with the TFT panel, but needs to be able to be combined with the TFT panel in accordance with a shape of the active area of the TFT panel. However, there is a problem in that it is difficult to electrically connect the TFT substrate and the perovskite single crystal, in general, because the perovskite single crystal does not grow on the TFT substrate. Accordingly, there is a need to research a new method and apparatus capable of maintain a thickness of about 0.5 mm to 2 mm, grow a single crystal having a large area, and also combine the single crystal with a substrate.

Accordingly, the inventors of the present disclosure developed an STIM integration growth apparatus and method capable of growing a perovskite single crystal having a plate form by adjusting the thickness and area of the perovskite single crystal and also integrating the perovskite single crystal with a desired shape and location of a substrate, as the results of close efforts to adjust the thickness and area of the perovskite single crystal according to its purposes and growing and integrating the perovskite single crystal at a desired substrate and location, and completed embodiments of the present disclosure.

### SUMMARY

According to a conventional technology using a spacer, it is impossible to grow a perovskite single crystal having a large area while maintaining a small thickness of about 0.5 mm to 2 mm.

Various embodiments are directed to providing a space-confined temperature gradient induced monolithic (STIM) integration growth apparatus and a growth method using the same.

Furthermore, various embodiments are directed to providing an STIM integrated growth apparatus and method capable of growing a single crystal having a plate form by adjusting the thickness and an area of the single crystal and integrating the single crystal at a desired shape and location of a substrate by using the STIM integration growth method completed according to an embodiment of the present disclosure, unlike a conventional method of growing a perovskite single crystal, which cannot implement a thickness and area that suit various purposes.

Objects of the present disclosure are not limited to the aforementioned contents, and the other technical objects not described above may be evidently understood by those skilled in the art from the following description.

In an embodiment of the present disclosure, a space-confined temperature gradient induced monolithic (STIM) integration growth apparatus capable of adjusting a thickness of a perovskite single crystal and growing a large-area perovskite single crystal may include an upper housing including a storage space in which a perovskite precursor solution is stored, a lower housing coupled to a lower part of the upper housing, and a temperature control device disposed under the lower housing. The lower housing may include a first frame, a second frame disposed to be spaced apart from the first frame, and a spacer that is disposed between the first frame and the second frame and that partitions a growth space for a perovskite single crystal seed.

Furthermore, a location of the perovskite single crystal seed disposed on a lower side of the growth space of the lower housing may sink into a fluid within the temperature control device. The fluid within the temperature control device may be maintained within a preset temperature range.

Furthermore, a height at which the growth space of the lower housing sinks into the fluid within the temperature control device may be controlled according to an up and down movement of the temperature control device or the lower housing.

Furthermore, the temperature control device may store silicon oil. A flow path of a liquid that circulates so that the liquid may be subjected to heat exchange with the silicon oil is formed. The temperature control device may include a double jacket beaker disposed so that at least a part of the lower housing sinks into the stored silicon oil. The STIM integrated growth apparatus may further include a circulation water tank that stores the liquid that circulates along the flow path and that is connected to the temperature control device so that the liquid circulates along the flow path.

Furthermore, the STIM integrated growth apparatus may further include a support jack that is disposed under the temperature control device and that adjusts a relative height between the lower housing and the temperature control device.

Furthermore, the upper housing may further include a first opening and a second opening into which the perovskite precursor solution is able to be introduced and that are upward opened, and a third opening that is downward opened. The lower housing may include a fourth opening that is upward opened so that the fourth opening corresponds to the third opening.

Furthermore, according to another embodiment of the present disclosure, a method of growing a perovskite single crystal may include partitioning a growth space for a perovskite single crystal seed by inserting a plurality of substrates into both sides of the spacer within the lower housing so that the plurality of substrates is spaced apart from each other, inserting the perovskite single crystal seed into the growth space, supplying a perovskite precursor solution through an opening of the upper housing, and disposing the lower housing so that at least a part of the lower housing sinks into a fluid stored within a temperature control device.

In this case, the thickness or size of a perovskite single crystal may be adjusted by adjusting the thickness or size of the growth space by changing the thickness or size of the spacer.

Furthermore, a temperature of the fluid stored within the temperature control device may be maintained in a temperature range in which only a growth of a perovskite single crystal occurs, but new nucleation does not occur through control over the temperature of the fluid. Furthermore, the method may further include controlling the height of the perovskite single crystal seed at which the perovskite single crystal seed sinks into the fluid within the temperature control device.

An embodiment of the present disclosure can provide the STIM integrated growth apparatus and method capable of adjusting the thickness of a perovskite single crystal and growing a large-area perovskite single crystal.

According to, an embodiment of the present disclosure has an advantage in that it can grow a single crystal having a plate form by adjusting the thickness and an area of the single crystal and can integrate the single crystal at a desired shape and location of a substrate by using the STIM integration growth method completed according to an embodiment of the present disclosure, unlike a conventional method of growing a perovskite single crystal, which cannot implement a thickness and area that suit various purposes.

The perovskite single crystal generated according to an embodiment of the present disclosure has effects in that the perovskite single crystal can be used in more various fields, can image an X-ray because the perovskite single crystal can be applied to a TFT panel, and can measure an X-ray even with a small X-ray dose because the perovskite single crystal can detect X-ray more sensitively.

Effects of the present disclosure are not limited to the aforementioned effects, and the other technical effects not described above may be evidently understood by those skilled in the art from the following description.

### BRIEF DESCRIPTION OF THE DRAWINGS

FIG. 1 is a perspective view illustrating the coupling of a lower housing and double jacket beaker of an STIM integrated growth apparatus capable of adjusting the thickness of a perovskite single crystal and growing a large-area perovskite single crystal according to an embodiment of the present disclosure.
FIG. 2 is a diagram illustrating the connection of the double jacket beaker and a circulation water tank according to an embodiment of the present disclosure.
FIG. 3 is a perspective view of the STIM integrated growth apparatus capable of adjusting the thickness of a perovskite single crystal and growing a large-area perovskite single crystal according to an embodiment of the present disclosure.
FIG. 4 is a perspective view of the STIM integrated growth apparatus capable of controlling the growth rate of a perovskite single crystal according to an embodiment of the present disclosure.
FIG. 5 is a diagram illustrating an upper housing of the STIM integrated growth apparatus capable of adjusting the thickness of a perovskite single crystal and growing a large-area perovskite single crystal according to an embodiment of the present disclosure.
FIG. 6 is a perspective view of a lower housing of the STIM integrated growth apparatus capable of adjusting the thickness of a perovskite single crystal and growing a large-area perovskite single crystal according to an embodiment of the present disclosure.
FIG. 7 is a process diagram illustrating an STIM integrated growth method capable of adjusting the thickness of a perovskite single crystal and growing a large-area perovskite single crystal according to an embodiment of the present disclosure.
FIG. 8 is a diagram illustrating a perovskite single crystal (50 mm x 50 mm x 1 mm) grown by the STIM integrated growth apparatus capable of adjusting the thickness of a perovskite single crystal and growing a large-area perovskite single crystal according to an embodiment of the present disclosure.

### DETAILED DESCRIPTION

Hereinafter, embodiments of the present disclosure are described in detail with reference to the accompanying drawings so that a person having ordinary knowledge in the art to which the present disclosure pertains can easily practice the embodiments. However, the present disclosure may be implemented in other various forms, and is not limited to the embodiments described herein. Furthermore, in order to clarify an embodiment of the present disclosure in the drawings, a part not related to the description is omitted, and similar reference numbers are used to refer to similar parts throughout the specification.

In the entire specification of the present disclosure, when it is described that one member is placed "on" the other member, this includes a case in which one member adjoins the other member and a case where a third member is interposed between the two members.

In the entire specification, unless explicitly described to the contrary, the word "include, have, or comprise" will be understood to imply the inclusion of stated components but not the exclusion of any other component. In the entire specification of this application, a term of a degree, such as "about" or "substantially", is used in a corresponding numerical value or used as a meaning close to the numerical value when unique manufacturing and an allowable error are presented in a described meaning, and is used to prevent an unconscious infringer from illegally using disclosed contents including a numerical value illustrated as being accurate or absolute in order to help understanding of the present disclosure. In the entire specification of this application, terms, such as a "step of (performing or doing) ~" or a "step of ~" does not mean a "step for ~."

In the entire specification of the present disclosure, the writing of "A and/or B" means "A or B" or "A and B".

Embodiments of the present disclosure are described in detail with reference to the accompanying drawings. However, the present disclosure may not be limited to such embodiments and drawings.

A first aspect of the present disclosure relates to a space-confined temperature gradient induced monolithic (STIM) integration growth apparatus 10 capable of adjusting the thickness of a perovskite single crystal and growing a large-area perovskite single crystal, and may provide the STIM integration growth apparatus 10 capable of adjusting the thickness of a perovskite single crystal and growing a large-area perovskite single crystal, including an upper housing 100 in which a first opening 110 and a second opening 120 that are upward opened in a gravity direction in which a perovskite precursor solution can be introduced are formed, a storage space 140 in which the perovskite precursor solution is stored is formed, and a third opening 130 that is downward opened in the gravity direction is formed; and a lower housing 300 that is coupled to a lower part of the upper housing 100 and in which a fourth opening 310 that is upward opened in the gravity direction is formed to correspond to the third opening 130. The lower housing 300 includes a first frame 320, a second frame 340 disposed to be spaced apart from the first frame 320, and a spacer 330 that is disposed between the first frame 320 and the second frame 340 and that partitions a growth space 350 of a perovskite single crystal seed. The growth space 350 is partitioned by a first substrate P1 and a second substrate P2 inserted into both sides of the spacer 330, respectively, and the spacer 330.

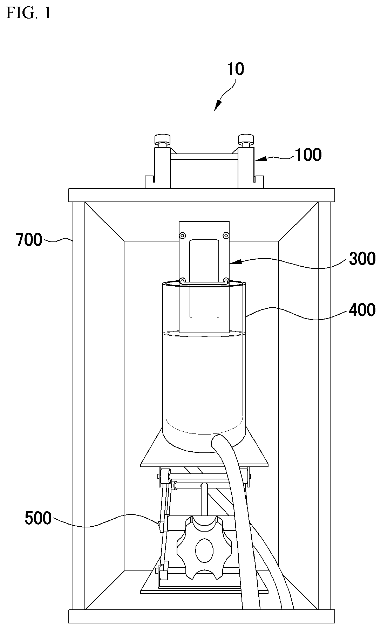

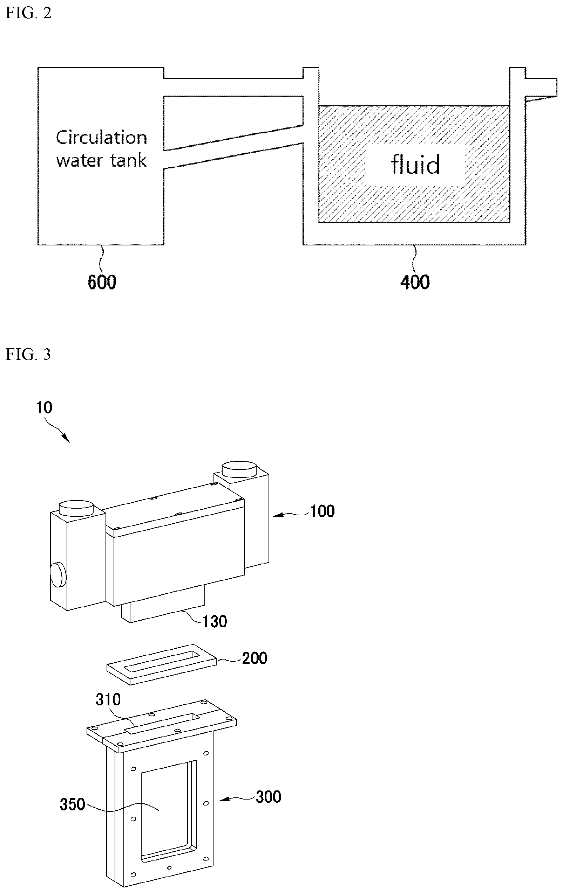

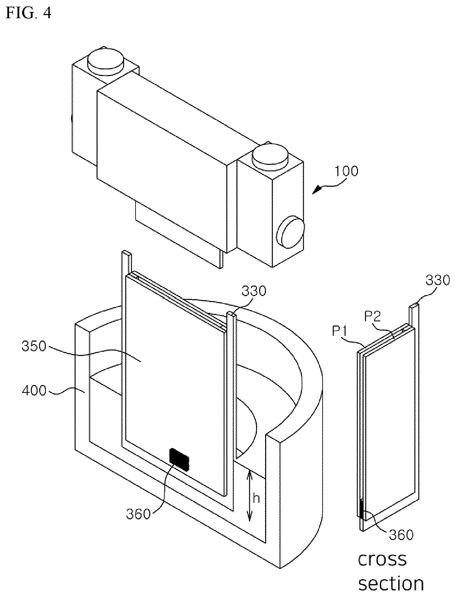

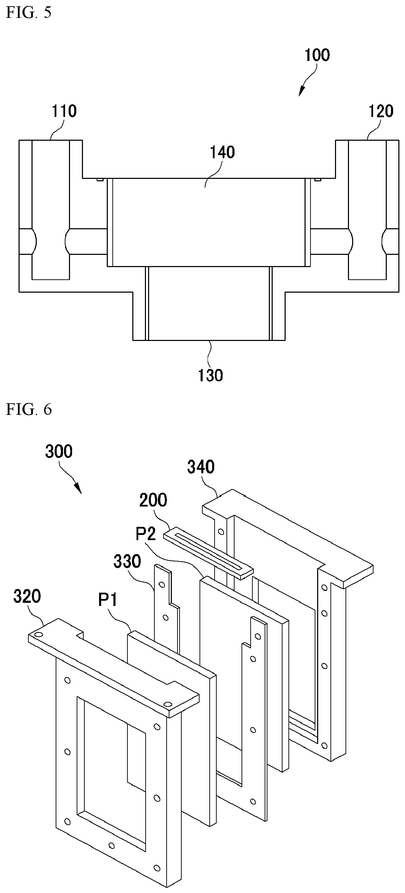

FIG. 1 is a perspective view illustrating the coupling of the lower housing 300 and temperature control device 400 of the STIM integrated growth apparatus 10 capable of adjusting the thickness of a perovskite single crystal and growing a large-area perovskite single crystal according to an embodiment of the present disclosure. FIG. 2 is a diagram illustrating the connection of the temperature control device 400 and a circulation water tank 600 according to an embodiment of the present disclosure. FIG. 3 is a perspective view of the STIM integrated growth apparatus 10 capable of adjusting the thickness of a perovskite single crystal and growing a large-area perovskite single crystal according to an embodiment of the present disclosure. FIG. 4 is a perspective view of the STIM integrated growth apparatus 10 capable of controlling the growth rate of a perovskite single crystal according to an embodiment of the present disclosure. FIG. 5 is a diagram illustrating the upper housing 100 of the STIM integrated growth apparatus 10 capable of adjusting the thickness of a perovskite single crystal and growing a large-area perovskite single crystal according to an embodiment of the present disclosure. FIG. 6 is a perspective view of the lower housing 300 of the STIM integrated growth apparatus 10 capable of adjusting the thickness of a perovskite single crystal and growing a large-area perovskite single crystal according to an embodiment of the present disclosure.

Referring to FIG. 4, the temperature control device 400, such as a container capable of storing a fluid, such as a beaker, is disposed under the lower housing 300 to which the upper housing 100 is coupled. A location of a perovskite single crystal seed 360 disposed on a lower side of the growth space 350 within the lower housing 300 is dipped in the fluid within the temperature control device 400. The fluid within the temperature control device 400 may be maintained within a preset temperature range. In this case, the fluid within the temperature control device 400 may be maintained within a temperature range in which only the growth of a perovskite single crystal occurs, but new nucleation does not occur through control over a temperature of the fluid stored in the temperature control device 400. The fluid for temperature control, which is stored in the temperature control device 400, may include a liquid, such as silicon oil that is used to maintain or control a temperature, or various types of gases which are used for temperature control.

Furthermore, a relative height between the lower housing 300 and the temperature control device 400 may be adjusted so that a depth at which the bottom of the lower housing 300 sinks into the temperature control device 400 is increased as the perovskite single crystal seed 360 grows. For example, the growth space 350 of the lower housing 300 may control the height at which the bottom of the lower housing 300 sinks into the liquid within the temperature control device 400 according to an up and down movement of the temperature control device 400 or the lower housing 300.

Furthermore, the temperature control device 400 may be formed of a container that stores a liquid therein, such as silicon oil, in which the flow path of the liquid subjected to heat exchange with the silicon oil is formed, and in which at least a part of the lower housing 300 can accommodate the liquid, such as silicon oil. The temperature control device 400 may be constructed in the form of a double jacket beaker for temperature control, for example. Furthermore, the temperature control device 400 may be a device constructed to control a surrounding temperature by using a gas, for example.

Referring to FIG. 5, in the STIM integrated growth apparatus 10 capable of adjusting the thickness of a perovskite single crystal and growing a large-area perovskite single crystal, the upper housing 100 may include the first opening 110, the second opening 120, the third opening 130, and the storage space 140. Specifically, a perovskite single crystal precursor solution may be supplied to the storage space 140 through the first opening 110 and the second opening 120.

Referring to FIG. 6, in the STIM integrated growth apparatus 10 capable of adjusting the thickness of a perovskite single crystal and growing a large-area perovskite single crystal, the lower housing 300 may include the fourth opening 310, the first frame 320, the second frame 340, the spacer 330, and the growth space 350. Specifically, the spacer 330 may be disposed between the first frame 320 and the second frame 340 disposed to be spaced apart from the first frame 320. The first substrate P1 may be disposed between the first frame 320 and the spacer 330 and the second substrate P2 may be disposed between the second frame 340 and the spacer 330 in order to partition the growth space 350 in which the perovskite single crystal seed 360 grows. The perovskite single crystal seed 360 may be inserted into the plurality of substrates within the growth space 350. The perovskite single crystal seed 360 may be grown by being integrated with the plurality of substrates.

Referring to FIG. 3, a gasket 200 may be disposed between the upper housing 100 and the lower housing 300 so that the gasket 200 corresponds to at least one of the third opening 130 of the upper housing 100 or the fourth opening 310 of the lower housing 300. Specifically, the third opening 130 of the upper housing 100 and the fourth opening 310 of the lower housing 300 may be connected by the gasket 200. Accordingly, the storage space 140 of the upper housing 100 and the growth space 350 of the lower housing 300 communicate with each other so that the perovskite single crystal precursor solution can be supplied to the growth space 350.

Referring back to FIG. 1, a part of the lower housing 300 of the STIM integrated growth apparatus 10 capable of adjusting the thickness of a perovskite single crystal and growing a large-area perovskite single crystal is fixed to sink into a fluid, such as silicon oil within the temperature control device 400. A case 700 may be used to protect the temperature control device 400 and the support jack 500.

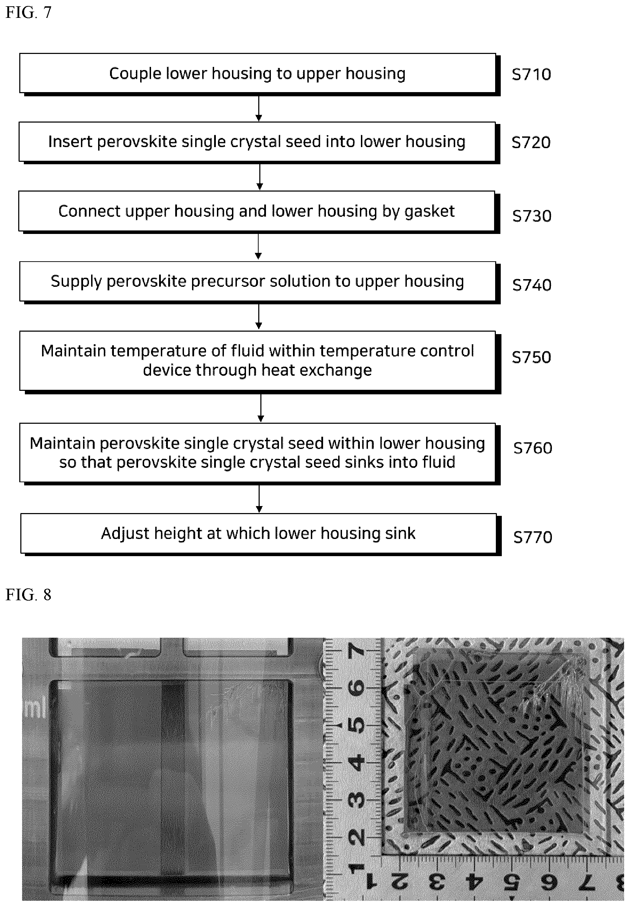

FIG. 7 is a process diagram illustrating an STIM integrated growth method capable of adjusting the thickness of a perovskite single crystal and growing a large-area perovskite single crystal according to an embodiment of the present disclosure.

In step S710, the lower housing 300 is coupled to the upper housing 100 by disposing the spacer 330 between the first frame 320 and the second frame 340 disposed to be spaced apart from the first frame 320.

In step S720, the growth space 350 is partitioned by inserting the first substrate P1 and the second substrate P2 into the lower housing 300 so that the first substrate P1 and the second substrate P2 are spaced apart from each other. The perovskite single crystal seed 360 is inserted into the growth space 350.

In step S730, in order to couple the upper housing 100 and the lower housing 300, the gasket 200 is disposed between the third opening 130 of the upper housing 100 and the fourth opening 310 of the lower housing 300 and fixed by a clamp.

In step S740, a perovskite precursor solution is supplied to the first opening 110 and second opening 120 of the upper housing 100 so that the perovskite precursor solution is supplied to the growth space 350 within the lower housing 300 through the storage space 140.

In step S750, as illustrated in FIG. 2, the temperature control device 400 is filled with a fluid, such as silicon oil, and the temperature control device 400 and the circulation water tank 600 are connected. Accordingly, the fluid is subjected to heat exchange so that the fluid can maintain a temperature range of 50°C to 54°C corresponding to an optimal growth zone temperature range.

In step S760, the perovskite single crystal seed 360 is disposed within the growth space 350 of the lower housing 300 so that the perovskite single crystal seed 360 sinks into the fluid within the temperature control device 400, for example, at a depth of 8 mm to 12 mm.

In step S770, a height at which the growth space 350 of the lower housing 300 sinks may be adjusted and controlled by adjusting a height at which the fluid within the temperature control device 400 and the perovskite single crystal seed 360 sink by using a support jack 500, for example, so that the height can be maintained as the perovskite single crystal seed is grown by being integrated with the substrate.

A second aspect of the present disclosure according to such a method relates to a method of growing a perovskite single crystal using the STIM integrated growth apparatus 10 including the upper housing 100 in which the storage space 140 in which a perovskite precursor solution is stored is formed and the lower housing 300 including the spacer 330 disposed between the first frame 320 and the second frame 340 that are disposed to be spaced apart from each other, and may provide a method of growing a perovskite single crystal, which can adjust the thickness of a perovskite single crystal and growing a large-area perovskite single crystal, including steps of (a) partitioning the growth space 350 for the perovskite single crystal seed 360 by inserting the plurality of substrates P1 and P2 into both sides of the spacer 330 within the lower housing 300 so that the plurality of substrates P1 and P2 is spaced apart from each other; (b) inserting the perovskite single crystal seed 360 into the growth space 350; (c) disposing the gasket 200 between the fourth opening 310 of the lower housing 300 and the third opening 130 of the upper housing 100 so that the growth space 350 communicates with the storage space 140; (d) supplying the perovskite precursor solution through the first opening 110 and second opening 120 of the upper housing 100; (e) storing silicon oil in the temperature control device 400 so that the flow path of a liquid that circulates and is subjected to heat exchange with the silicon oil, storing the liquid that circulates along the flow path, and disposing the circulation water tank 600 connected to the temperature control device 400; and (f) disposing the lower housing 300 so that at least a part of the lower housing 300 sinks into the stored silicon oil.

FIG. 8 is a diagram illustrating a perovskite single crystal (50 mm x 50 mm x 1 mm) grown by the STIM integrated growth apparatus 10 capable of adjusting the thickness of a perovskite single crystal and growing a large-area perovskite single crystal according to an embodiment of the present disclosure. It is possible to grow a large-area perovskite single crystal having a small thickness of 50 mm x 50 mm x 1 mm, which cannot be achieved by a conventional solution process, by using a growth method capable of adjusting the thickness of a perovskite single crystal and growing a large-area perovskite single crystal through the STIM integrated growth apparatus 10 according to an embodiment of the present disclosure.

The term "perovskite" that is used in the entire specification of the present disclosure collectively refers to a substance having a crystal structure, such as [CaTiO3], and is expressed as a common equation AMX3. In the equation, A includes an organic cation, an alkali-metal cation, or a mixed cation of the organic cation and the alkali-metal cation. M includes Cu2+, Ni2+, Co2+, Fe2+, Mn2+, Cr2+, Pd2+, Cd2+, Yb2+, Pb2+, Sn2+, Ge2+, and a metal cation selected from a group consisting of combinations of them. X refers to halogen ions. The perovskite material may be used in a direct x-ray detector because the perovskite material has high radiosensitivity, detects a wide energy range, and has a fast response time and a high spatial solution.

The term "perovskite precursor solution" that is used in the entire specification of the present disclosure has a form of a precursor of a perovskite material, and generally includes an organic solvent and perovskite components. The perovskite precursor solution may be used to easily manufacture and process a perovskite material. In general, the perovskite precursor solution includes positive ions, negative ions, and an organic solvent, that is, components of the perovskite material. In general, lead ions

(Pb2+) are used as the positive ions. Hydrogenic sulfuric acid (Halide, X-), chloride (Cl-), bromide (Br-), or iodide (I-) is used as the negative ions. Dimethylformamide (DMF), dimethyl sulfoxide (DMSO), or gamma-butyrolactone (GBL) is used as the organic solvent. The perovskite precursor solution is basically used to manufacture the perovskite material, and may be used to manufacture a perovskite thin film by using various methods and applied to various apparatuses.

In an embodiment of the present disclosure, a fluid within the temperature control device 400 that is used to maintain a temperature of the lower housing 300 may be a liquid, such as silicon oil, or a gas, but the present disclosure is not limited thereto.

In an embodiment of the present disclosure, a liquid that is supplied to the circulation water tank 600 connected to the temperature control device 400 may be water (H2O), but the present disclosure is not limited thereto.

In an embodiment of the present disclosure, the spacer 330 may be a silicon material, but the present disclosure is not limited thereto.

In an embodiment of the present disclosure, the thickness or size of the growth space 350 may be adjusted by changing the thickness or size of the spacer 330, but the present disclosure is not limited thereto.

In an embodiment of the present disclosure, the amount of the perovskite precursor solution that is inserted into the storage space 140 of the upper housing 100 may be adjusted in accordance with the size of a single crystal to be grown, but the present disclosure is not limited thereto.

In an embodiment of the present disclosure, a temperature corresponding to an optimal growth zone in which only the growth of a single crystal occurs, but new nucleation does not occur may be 50°C to 54°C, preferably, about 52°C, but the present disclosure is not limited thereto.

In an embodiment of the present disclosure, the STIM integrated growth apparatus 10 capable of adjusting the thickness of a perovskite single crystal and growing a large-area perovskite single crystal may be applied to various fields, such as a solar cell and a gamma ray detector, because the STIM integrated growth apparatus can grow a perovskite single crystal by adjusting the thickness and area of the perovskite single crystal, unlike the existing method.

In an embodiment of the present disclosure, the STIM integrated growth apparatus 10 can grow a perovskite single crystal by integrating the perovskite single crystal with a substrate and also grow the perovskite single crystal at a desired location of the substrate, unlike the existing method, and may be applied to the medical field because the STIM integrated growth apparatus can image an X-ray by being applied to a TFT panel.

In an embodiment of the present disclosure, the STIM integration growth apparatus 10 capable of adjusting the thickness of a perovskite single crystal and growing a large-area perovskite single crystal includes the upper housing 100 in which the first opening 110 and the second opening 120 that are upward opened in a gravity direction in which a perovskite precursor solution can be introduced are formed, the storage space 140 that stores the perovskite precursor solution is formed, and the third opening 130 that is downward opened in the gravity direction is formed; and the lower housing 300 that is coupled to a lower part of the upper housing 100 and in which the fourth opening 310 that is upward opened in the gravity direction is formed to correspond to the third opening 130. The lower housing 300 includes the first frame 320, the second frame 340 disposed to be spaced apart from the first frame 320, and the spacer 330 that is disposed between the first frame 320 and the second frame 340 and that partitions the growth space 350 of the perovskite single crystal seed. The growth space 350 is partitioned by the first substrate P1 and the second substrate P2 inserted into both sides of the spacer 330, respectively, and the spacer 330.

In an embodiment of the present disclosure, in the STIM integrated growth apparatus 10 capable of adjusting the thickness of a perovskite single crystal and growing a large-area perovskite single crystal, the storage space 140 is connected to the lower housing 300 so that the storage space 140 communicates with the growth space 350. The upper housing 100 is constructed to supply a perovskite precursor solution to the growth space 350.

In an embodiment of the present disclosure, the STIM integrated growth apparatus 10 capable of adjusting the thickness of a perovskite single crystal and growing a large-area perovskite single crystal further includes the gasket 200 disposed between the upper housing 100 and the lower housing 300 so that the gasket 200 corresponds to at least one of the third opening 130 or the fourth opening 310.

In an embodiment of the present disclosure, the STIM integrated growth apparatus 10 capable of adjusting the thickness of a perovskite single crystal and growing a large-area perovskite single crystal further includes the temperature control device 400 in which silicon oil is stored, the flow path of a liquid that circulates so that the liquid is subjected to heat exchange with the silicon oil is formed, and at least a part of the lower housing 300 is disposed to sink into the stored silicon oil; and the circulation water tank 600 in which the liquid that circulates along the flow path is stored and that is connected to the temperature control device 400 so that the liquid circulates along the flow path.

In an embodiment of the present disclosure, the STIM integrated growth apparatus 10 capable of adjusting the thickness of a perovskite single crystal and growing a large-area perovskite single crystal further includes the support jack 500 that is disposed under the temperature control device 400 and that adjusts a relative height between the lower housing 300 and the temperature control device 400.

In an embodiment of the present disclosure, the method of growing a perovskite single crystal using the STIM integrated growth apparatus 10 including the upper housing 100 in which the storage space 140 in which a perovskite precursor solution is stored is formed and the lower housing 300 including the spacer 330 disposed between the first frame 320 and the second frame 340 that are disposed to be spaced apart from each other is a method of growing a perovskite single crystal, which can adjust the thickness of a perovskite single crystal and growing a large-area perovskite single crystal, and includes steps of (a) partitioning the growth space 350 for the perovskite single crystal seed 360 by inserting the plurality of substrates P1 and P2 into both sides of the spacer 330 within the lower housing 300 so that the plurality of substrates P1 and P2 is spaced apart from each other; (b) inserting the perovskite single crystal seed 360 into the growth space 350; (c) disposing the gasket 200 between the fourth opening 310 of the lower housing 300 and the third opening 130 of the upper housing 100 so that the growth space 350 communicates with the storage space 140; (d) supplying the perovskite precursor solution through the first opening 110 and second opening 120 of the upper housing 100; (e) storing silicon oil in the temperature control device 400 so that the flow path of a liquid that circulates and is subjected to heat exchange with the silicon oil, storing the liquid that circulates along the flow path, and disposing the circulation water tank 600 connected to the temperature control device 400; and (f) disposing the lower housing 300 so that at least a part of the lower housing 300 sinks into the stored silicon oil.

In the method of growing a perovskite single crystal, which adjust the thickness of a perovskite single crystal and growing a large-area perovskite single crystal according to an embodiment of the present disclosure, in step (a), the thickness or size of a perovskite single crystal can be adjusted by adjusting the thickness or size of the growth space 350 by adjusting the thickness or size of the spacer 330.

In the method of growing a perovskite single crystal, which adjust the thickness of a perovskite single crystal and growing a large-area perovskite single crystal according to an embodiment of the present disclosure, in step (e), a temperature of the liquid is maintained in a temperature range in which only the growth of a perovskite single crystal occurs, but new nucleation does not occur through the heat exchange.

In the method of growing a perovskite single crystal, which adjust the thickness of a perovskite single crystal and growing a large-area perovskite single crystal according to an embodiment of the present disclosure, in step (e), the growth of the perovskite single crystal is induced by adjusting the support jack 500 so that the perovskite single crystal seed sinks into the silicon oil within the temperature control device 400 at a depth of 8 mm to 10 mm.

The description of the present disclosure is illustrative, and a person having ordinary knowledge in the art to which the present disclosure pertains will understand that the present disclosure may be easily modified in other detailed forms without changing the technical spirit or essential characteristic of the present disclosure. Accordingly, it should be construed that the aforementioned embodiments are only illustrative in all aspects, and are not limitative. For example, components described in the singular form may be carried out in a distributed form. Likewise, components described in a distributed form may also be carried out in a combined form.

The scope of the present disclosure is defined by the appended claims rather than by the detailed description, and all changes or modifications derived from the meanings and scope of the claims and equivalents thereto should be interpreted as being included in the scope of the present disclosure.

## Claims

1. A space-confined temperature gradient induced monolithic (STIM) integration growth apparatus capable of adjusting a thickness of a perovskite single crystal and growing a large-area perovskite single crystal, the STIM integrated growth apparatus comprising:
an upper housing comprising a storage space in which a perovskite precursor solution is stored;
a lower housing coupled to a lower part of the upper housing; and
a temperature control device disposed under the lower housing,
wherein the lower housing comprises a first frame, a second frame disposed to be spaced apart from the first frame, and a spacer that is disposed between the first frame and the second frame and that partitions a growth space for a perovskite single crystal seed.

2. The STIM integrated growth apparatus of claim 1, wherein:
a location of the perovskite single crystal seed disposed on a lower side of the growth space of the lower housing sinks into a fluid within the temperature control device, and
the fluid within the temperature control device is maintained within a preset temperature range.

3. The STIM integrated growth apparatus of claim 2, wherein a height at which the growth space of the lower housing sinks into the fluid within the temperature control device is able to be controlled according to an up and down movement of the temperature control device or the lower housing.

4. The STIM integrated growth apparatus of claim 2, wherein:
the temperature control device stores silicon oil,
a flow path of a liquid that circulates so that the liquid is able to be subjected to heat exchange with the silicon oil is formed,
the temperature control device comprises a double jacket beaker disposed so that at least a part of the lower housing sinks into the stored silicon oil, and
the STIM integrated growth apparatus further comprises a circulation water tank that stores the liquid that circulates along the flow path and that is connected to the temperature control device so that the liquid circulates along the flow path.

5. The STIM integrated growth apparatus of claim 4, further comprising a support jack that is disposed under the temperature control device and that adjusts a relative height between the lower housing and the temperature control device.

6. The STIM integrated growth apparatus of claim 1, wherein:
the upper housing further comprises a first opening and a second opening into which the perovskite precursor solution is able to be introduced and that are upward opened, and a third opening that is downward opened, and
the lower housing comprises a fourth opening that is upward opened so that fourth opening corresponds to the third opening.

7. A method of growing a perovskite single crystal using a space-confined temperature gradient induced monolithic (STIM) integrated growth apparatus comprising an upper housing in which a storage space in which a perovskite precursor solution is stored is formed and a lower housing comprising a spacer disposed between a first frame and a second frame that are disposed to be spaced apart from each other, the method comprising:
partitioning a growth space for a perovskite single crystal seed by inserting a plurality of substrates into both sides of the spacer within the lower housing so that the plurality of substrates is spaced apart from each other;
inserting the perovskite single crystal seed into the growth space;
supplying a perovskite precursor solution through an opening of the upper housing; and
disposing the lower housing so that at least a part of the lower housing sinks into a fluid stored within a temperature control device.

8. The method of claim 7, wherein a thickness or size of a perovskite single crystal is adjustable by adjusting a thickness or size of the growth space by changing a thickness or size of the spacer.

9. The method of claim 7, wherein a temperature of the fluid stored within the temperature control device is maintained in a temperature range in which only a growth of a perovskite single crystal occurs, but new nucleation does not occur through control over the temperature of the fluid.

10. The method of claim 7, further comprising controlling a height of the perovskite single crystal seed at which the perovskite single crystal seed sinks into the fluid within the temperature control device.
